# EUROPEAN PATENT APPLICATION

(11) **EP 3 587 171 A1**
(43) Date of publication of application: **01.01.2020**
(21) Application number: 19154151.5
(22) Date of filing: 29.01.2019
(51) Int. Cl.: B60L 53/80

(54) **METHOD OF INFORMATION PROVISION AND ELECTRIC CARRIER SYSTEM**

(30) Priority: 28.06.2018 TW 10722272
(71) Applicant: Kwang Yang Motor Co., Ltd., Kaohsiung City 80794 (TW)
(72) Inventor: LU, Chun-Ting, 83063 Kaohsiung City (TW); TU, Chia-Cheng, 80794 Kaohsiung (TW); LIU, Te-Chuan, 11501 Taipei City (TW); LIN, Jen-Chiun, 11501 Taipei City (TW); CHEN, Yuh-Rey, 11501 Taipei City (TW); CHUANG, Po-Yu, 11501 Taipei City (TW)
(74) Representative: Stöckeler, Ferdinand

(57) **Abstract**

A method of information provision is to be implemented by an electric carrier system which includes an electric carrier device (2), a power supply device (3) and an electronic device (4). The electric carrier device (2) stores an individual carrier identifier and carrier information. The power supply device (3) provides electrical energy to the electric carrier device (2), and stores a set of reference carrier identifiers and battery information. The electronic device (4) is communicable with the electric carrier device (2) and a server (5). The method includes: by the electric carrier device (2) when in communication with the electric device (4), transmitting, to the electronic device (4), integrated information that includes the carrier information and the battery information; and by the electronic device (4) when the electronic device (4) is in communication with the server (5), transmitting the integrated information to the server (5).

## Description

The disclosure relates to a method of information provision and an electric carrier system, and more particularly to a method of information provision for an electric vehicle, and an electric carrier system including an electric vehicle.

Conventionally, a battery installed on an electric carrier device is mainly inspected during routine maintenance of the electric carrier device or when the battery is swapped for a fully charged battery- at a battery swapping station. Therefore, a health status of the battery cannot be monitored in real time, resulting in an increased risk of battery failure.

Therefore, an object of the disclosure is to provide a method of information provision and an electric carrier system that can alleviate at least one of the drawbacks of the prior art.

According to one aspect of the disclosure, the electric carrier system is communicable with a server. The electric carrier system includes an electric carrier device, a power supply device and an electronic device. The electric carrier device is configured to store vehicle information that is related to the electric carrier device. The power supply device is electrically connected to the electric carrier device, and is configured to store integrated information that is related to the power supply device and the vehicle information. The electronic device is communicable with the electric carrier device and the server. When the electronic device is in communication with the electric carrier device, the electric carrier device transmits the integrated information stored in the power supply device to the electronic device. When the electronic device is in communication with the server, the electronic device transmits the integrated information to the server.

According to another aspect of the disclosure, the method is to be implemented by the electric carrier system described previously. The electric carrier device further stores an individual carrier identifier. The power supply device is adapted to provide electrical energy to the electric carrier device, and stores a set of reference carrier identifiers and battery information which is related to the power supply device. The electronic device is communicable with the electric carrier device and the server. The method includes steps of:
by the electric carrier device when the electronic device is in communication with the electric carrier device, transmitting, to the electronic device, integrated information that includes the vehicle information and the battery information; and
by the electronic device when the electronic device is in communication with the server, transmitting the integrated information to the server.

According to still another aspect of the disclosure, the method of information provision is to be implemented by a variant of the electric carrier system previously described. The electric carrier device is communicable directly with the server. The method includes steps of:
by the electric carrier device when the electric carrier device is electrically connected to the power supply device, determining a status of a communicable connection between the electric carrier device and the server; and
by the electric carrier device when it is determined by the electric carrier device that the electric carrier device is communicably connected with the server, transmitting the integrated information to the server.

Other features and advantages of the disclosure will become apparent in the following detailed description of the embodiments with reference to the accompanying drawings, of which:
Figure 1 is a flow chart illustrating a first embodiment of a method of information provision according to the disclosure;
Figure 2 is a block diagram illustrating an embodiment of an electric carrier system utilized by the first embodiment of the method of information provision according to the disclosure;
Figure 3 is a flow chart illustrating a second embodiment of the method of information provision according to the disclosure; and
Figure 4 is a block diagram illustrating a variant embodiment of the electric carrier system utilized by the second embodiment of the method of information provision according to the disclosure.

Before the disclosure is described in greater detail, it should be noted that where considered appropriate, reference numerals or terminal portions of reference numerals have been repeated among the figures to indicate corresponding or analogous elements, which may optionally have similar characteristics.

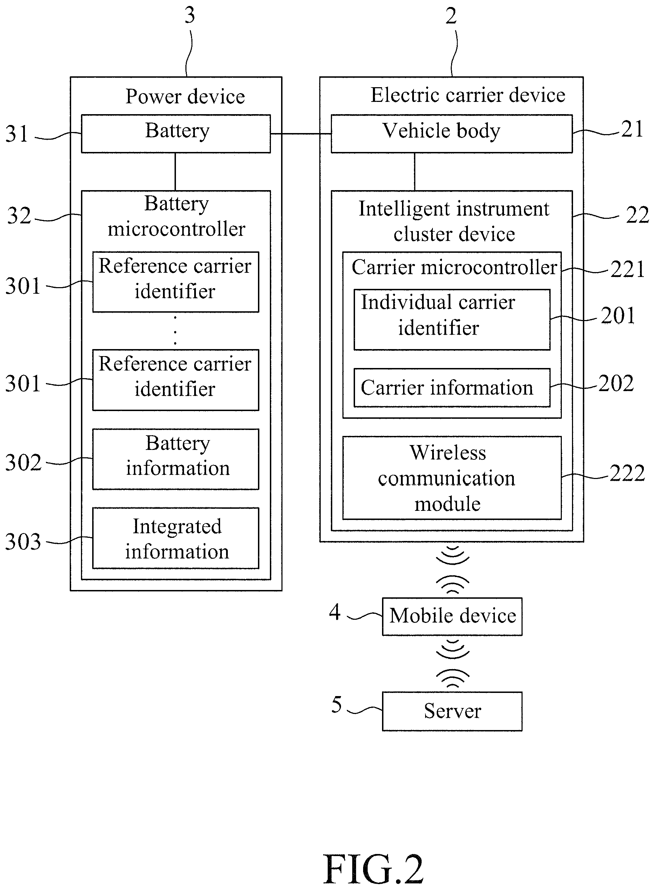

Referring to Figure 2, an embodiment of an electric carrier system is illustrated. The electric carrier system is to be utilized to implement a method of information provision according to the disclosure, such that users, battery developers or equipment suppliers of electric carrier devices are allowed to access information associated with conditions of an electric carrier device and a battery installed on the electric carrier device.

The electric carrier system is communicable with a server 5. The electric carrier system includes an electric carrier device 2, a power supply device 3 and an electronic device 4.

The electric carrier device 2 is configured to store carrier information 202 that is associated with the electric carrier device 2, and to store an individual carrier identifier 201 that is unique. In this embodiment, the electric carrier device 2 is implemented to be an electric vehicle (EV), but implementation of the electric carrier device 2 is not limited to the disclosure herein and may vary in other embodiments. In this embodiment, the individual carrier identifier 201 is implemented to be a vehicle control unit (VCU) number, but implementation thereof is not limited thereto and may vary in other embodiments.

In this embodiment, the electric carrier device 2 includes a vehicle body 21, and an intelligent instrument cluster device 22 that is disposed on the vehicle body 21. The intelligent instrument cluster device 22 includes a carrier microcontroller 221 that stores the individual carrier identifier 201 and the carrier information 202, and a wireless communication module 222 that is wirelessly communicable with the electronic device 4. In this embodiment, the wireless communication module 222 is implemented to be a Bluetooth communication module, but implementation of the wireless communication module 222 is not limited to the disclosure herein and may vary in other embodiments. It is worth noting that the carrier microcontroller 221 is configured to record information related to mileage, drive time, instantaneous speed and maximum speed of the electric carrier device 2 to result in the carrier information 202.

The power supply device 3 is to be electrically connected to the electric carrier device 2, and is adapted to provide electrical energy to the electric carrier device 2. The power supply device 3 is further configured to store a set of reference carrier identifiers 301, battery information 302 that relates to the power supply device 3, and integrated information 303 that is obtained by integrating the battery information 302 and the carrier information 202. The reference carrier identifiers 301 in the set of reference carrier identifiers 301 each correspond to the vehicle body of an electric carrier device.

Specifically speaking, the power supply device 3 includes a battery 31 that is configured to provide electrical energy to the vehicle body 21, and a battery microcontroller 32 that is electrically connected to the battery 31 and that is configured to store the set of reference carrier identifiers 301 and the battery information 302. The battery information 302 contains information obtained based on discharging history of the battery 31 and related to residual electrical energy of the battery 31, total usage time of the battery 31, residual lifetime of the battery 31, mileage corresponding to usage of the battery 31 and average operating temperature of the battery 31. In this embodiment, the battery microcontroller 32 is implemented to be a battery management system (BMS), but implementation of the battery microcontroller 32 is not limited thereto and may vary in other embodiments .

The electronic device 4 is installed with application software that is developed by developers of the electric carrier system so as to be communicable with the electric carrier device 2 and the server 5 for data transmission. In this embodiment, the electronic device 4 is implemented to be a mobile device, such as a smartphone or a tablet, but implementation of the electronic device 4 is not limited thereto and may vary in other embodiments . The electronic device 4 is configured to be operated to communicate with the wireless communication module 222 of the electric carrier device 2 based on Bluetooth protocols so as to be paired with the electric carrier device 2 and to receive data from the electric carrier device 2. The electronic device 4 may be owned by a user, a battery developer or an equipment supplier of electric carrier devices, but ownership of the electronic device 4 is not limited to the disclosure herein and may vary in other embodiments.

The server 5 is configured to communicate with the electronic device 4, and to receive, store and process data transmitted by the electronic device 4. In this embodiment, the server 5 is implemented to be a personal computer or a cloud server, and to be communicable with the electronic device 4 based on WiFi technology, Bluetooth protocols or fiber-optic communication, but implementation of the server 5 is not limited to the disclosure herein and may vary in other embodiments.

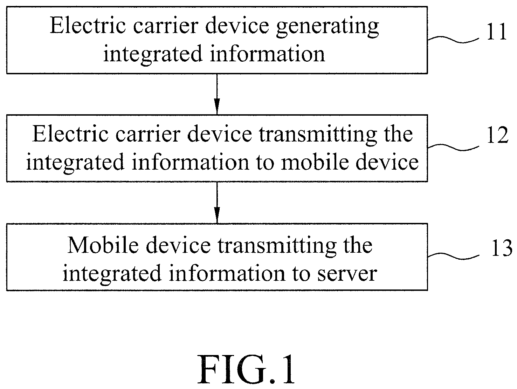

Referring to Figure 1, a first embodiment of the method of information provision according to this disclosure is illustrated. The method of information provision is to be implemented by the electric carrier system that is previously described. The method includes steps 11 to 13 described as follows.

In step 11, when the battery 31 is electrically connected to the vehicle body 21, the electric carrier device 2 is configured to determine whether the individual carrier identifier 201 stored in the electric carrier device 2 matches one of the reference carrier identifiers 301 from the set of reference carrier identifiers 301. The electric carrier device 2 is configured to, when it is determined that the individual carrier identifier 201 matches one of the reference carrier identifiers 301 from the set of reference carrier identifiers 301, transmit the carrier information 202 to the power supply device 3 so as to enable the power supply device 3 to integrate the carrier information 202 thus transmitted by the electric carrier device 2 and the battery information 302 stored in the power supply device 3 into the integrated information 303. Specifically speaking, when the power supply device 3 is disposed on the electric carrier device 2 and the battery 31 thereof is electrically connected to the vehicle body 21, the carrier microcontroller 221 of the intelligent instrument cluster device 22 of the electric carrier device 2 accesses the set of reference carrier identifiers 301 stored in the power supply device 3, and determines whether the individual carrier identifier 201 stored in the electric carrier device 2 matches one of the reference carrier identifiers 301 from the set of reference carrier identifiers 301 stored in the power supply device 3. When it is determined by the carrier microcontroller 221 that the individual carrier identifier 201 matches one of the reference carrier identifiers 301 from the set of reference carrier identifiers 301, the carrier microcontroller 221 transmits the carrier information 202 via a controller area network (CAN), which improves reliability of signal transmission, to the battery microcontroller 32 of the power supply device 3 to enable the battery microcontroller 32 to integrate the received carrier information 202 and the battery information 302 stored in the power supply device 3 into the integrated information 303 and to store the integrated information 303. The battery microcontroller 32 is further enabled to control the battery 31 to provide the electrical energy to the vehicle body 21 of the electric carrier device 2.

In step 12, when the electronic device 4 is in communication with the electric carrier device 2, the electric carrier device 2 transmits the integrated information 303 stored in the power supply device 3 to the electronic device 4. Specifically speaking, when the electronic device 4 is in communication with the wireless communication module 222 of the electric carrier device 2 based on Bluetooth protocols and is successfully paired with the wireless communication module 222, the carrier microcontroller 221 of the electric carrier device 2 loads the integrated information 303 stored in the battery microcontroller 32, and transmits the integrated information 303 via the wireless communication module 222 to the electronic device 4.

In step 13, when the electronic device 4 is in communication with the server 5, the electronic device 4 transmits the integrated information 303 to the server 5. The electronic device 4 is configured to, when not in communication with the server 5, store the integrated information 303 until the electronic device 4 is in communication with the server 5. Specifically speaking, after receiving the integrated information 303 from the electric carrier device 2, the electronic device 4 determines whether the electronic device 4 is in communication with the server 5. When it is determined by the electronic device 4 that the electronic device 4 is in communication with the server 5, the electronic device 4 transmits the integrated information 303 to the server 5 so as to enable the server 5 to store the integrated information 303. When it is determined by the electronic device 4 that the electronic device 4 is not in communication with the server 5, the electronic device 4 stores the integrated information 303 received from the electric carrier device 2 until it is determined by the electronic device 4 that the electronic device 4 is in communication with the server 5, at which time the electronic device 4 transmits the integrated information 303 to the server 5 so as to enable the server 5 to store the integrated information 303.

Moreover, the electronic device 4 may be configured to display the integrated information 303 according to settings of the application software installed on the electronic device 4. Therefore, the users, the developers or the equipment suppliers of electric carrier devices may be able to conveniently access the integrated information 303 stored in the server 5 so as to monitor conditions of the electric carrier device 2 and the power supply device 3 at any time. In this way, the users may respond to the conditions of the electric carrier device 2 and the power supply device 3 more promptly, and the developers or the equipment suppliers may be able to improve the quality of products based on the integrated information 303. In addition, the application software installed on the electronic device 4 may be designed to automatically notify the user of the conditions of the electric carrier device 2 and the power supply device 3 so as to enable the user to determine whether to perform routine maintenance on the electric carrier device 2 or the power supply device 3.

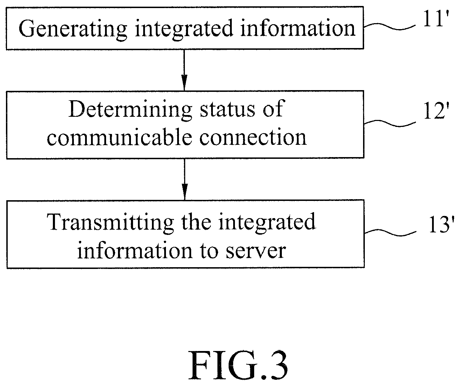

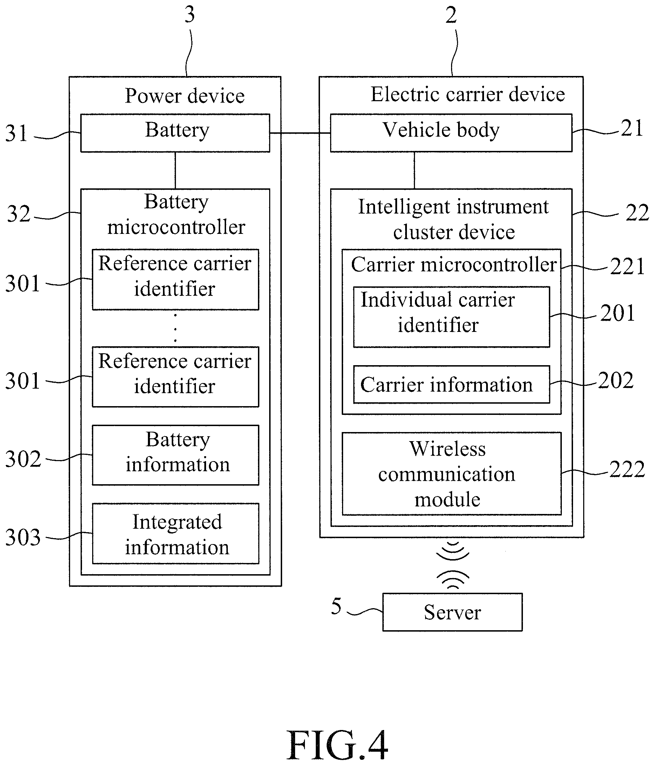

Referring to Figure 3, a second embodiment of the method of information provision is illustrated. The second embodiment of the method according to the disclosure is to be implemented by a variant embodiment of the electric carrier system illustrated in Figure 4.

As shown in Figure 4, the variant embodiment of the electric carrier system is similar to the embodiment that is previously described and illustrated in Figure 2, but is different therefrom in that the electric carrier device 2 of the variant embodiment is configured to directly communicate with the server 5 via the wireless communication module 222. Specifically speaking, in this embodiment, the intelligent instrument cluster device 22 of the electric carrier device 2 is configured to communicate with the server 5 via the wireless communication module 222 based on WiFi technology, Bluetooth protocols or fiber-optic communication, but implementation of the communication is not limited to the disclosure herein and may vary in other embodiments.

As shown in Figure 3, the second embodiment of the method includes steps 11' to 13'. Since steps 11' in the second embodiment of the method is similar to step 11 in the first embodiment of the method of this disclosure, only steps 12' and 13' which are different from steps 12 and 13 in the first embodiment are described, for the sake of brevity.

In step 12', when the electric carrier device 2 is electrically connected to the power supply device 3 and the power supply device 3 stores the integrated information 303 obtained in step 11' (identical to step 11), the electric carrier device 2 determines a status of a communicable connection between the electric carrier device 2 and the server 5. Specifically speaking, in this embodiment, when the battery microcontroller 32 controls the battery 31 to provide electrical energy to the vehicle body 21, the carrier microcontroller 221 controls the wireless communication module 222 to communicate with the server 5, and determines the status of the communicable connection between the electric carrier device 2 and the server 5.

In step 13', when it is determined by the electric carrier device 2 that the electric carrier device 2 has been communicably connected with the server 5, the electric carrier device 2 transmits the integrated information 303 to the server 5. Specifically speaking, in this embodiment, when the carrier microcontroller 221 determines that the wireless communication module 222 is communicating with the server 5, the carrier microcontroller 221 loads the integrated information 303 stored in the battery microcontroller 32, and transmits the integrated information 303 via the wireless communication module 222 to the server 5 so as to enable the server 5 to store the integrated information 303.

Similarly, the users, the developers or the equipment suppliers of electric carrier devices may be able to conveniently access the integrated information 303 stored in the server 5 so as to monitor conditions of the electric carrier device 2 and the power supply device 3 at any time. In this way, the inconvenience that the status of the battery can only be inspected during routine maintenance or battery swapping at a battery swapping station may be improved.

In summary, according to the disclosure, the method of information provision is to be implemented by the electric carrier system which is communicable with the server 5. The integrated information 303 that includes the carrier information 202 and the battery information 302 is initially stored in the power supply device 3 of the electric carrier system, and is then transmitted to the server 5 via the electronic device 4 or directly transmitted to the server 5. Since the integrated information 303 is stored in the server 5, the conditions of the electric carrier device 2 and the power supply device 3 can be conveniently inspected at any time by accessing the server 5.

In the description above, for the purposes of explanation, numerous specific details have been set forth in order to provide a thorough understanding of the embodiments. It will be apparent, however, to one skilled in the art, that one or more other embodiments may be practiced without some of these specific details. It should also be appreciated that reference throughout this specification to "one embodiment," "an embodiment," an embodiment with an indication of an ordinal number and so forth means that a particular feature, structure, or characteristic may be included in the practice of the disclosure. It should be further appreciated that in the description, various features are sometimes grouped together in a single embodiment, figure, or description thereof for the purpose of streamlining the disclosure and aiding in the understanding of various inventive aspects, and that one or more features or specific details from one embodiment may be practiced together with one or more features or specific details from another embodiment, where appropriate, in the practice of the disclosure.

## Claims

1. A method of information provision, the method to be implemented by an electric carrier system, the electric carrier system including an electric carrier device (2), a power supply device (3) and an electronic device (4), the electric carrier device (2) storing an individual carrier identifier (201) and carrier information (202) that is related to the electric carrier device (2), the power supply device (3) adapted to provide electrical energy to the electric carrier device (2), and storing a set of reference carrier identifiers (301) and battery information (302) which is related to the power supply device (3), the electronic device (4) communicable with the electric carrier device (2) and a server (5), said method **characterized by**:
by the electric carrier device (2) when the electronic device (4) is in communication with the electric carrier device (2), transmitting, to the electronic device (4), integrated information (303) that includes the carrier information (202) and the battery information (302); and
by the electronic device (4) when the electronic device (4) is in communication with the server (5), transmitting the integrated information (303) to the server (5).

2. The method as claimed in claim 1, further **characterized by**:
by the electronic device (4) when the electronic device (4) is not in communication with the server (5), storing the integrated information (303) received from the electric carrier device (2).

3. The method as claimed in claim 2, **characterized in that** the transmitting, to the electronic device (4), integrated information (303) includes, by the electric carrier device (2), communicating with the electronic device (4) based on Bluetooth protocols.

4. The method as claimed in claim 3, further **characterized by**:
by the electric carrier device (2), determining whether the individual carrier identifier (201) stored in the electric carrier device (2) matches one of the reference carrier identifiers (301) from the set of reference carrier identifiers (301) stored in the power supply device (3), and when it is determined that the individual carrier identifier (201) matches one of the reference carrier identifiers (301) from the set of reference carrier identifiers (301), transmitting the carrier information (202) to the power supply device (3) to enable the power supply device (3) to integrate the carrier information (202) and the battery information (302) stored in the power supply device (3) into the integrated information (303), and to provide the electrical energy to the electric carrier device (2).

5. An electric carrier system, said electric carrier system communicable with a server (5), and **characterized by**:
an electric carrier device (2) configured to store carrier information (202) that is related to said electric carrier device (2);
a power supply device (3) electrically connected to said electric carrier device (2), and configured to store integrated information (303) that is related to said power supply device (3) and the carrier information (202); and
an electronic device (4) communicable with said electric carrier device (2) and the server (5), and
wherein when said electronic device (4) is in communication with said electric carrier device (2), said electric carrier device (2) transmits the integrated information (303) stored in said power supply device (3) to said electronic device (4), and
when said electronic device (4) is in communication with the server (5), said electronic device (4) transmits the integrated information (303) to the server (5).

6. The electric carrier system as claimed in claim 5, **characterized in that** said electronic device (4) is configured to, when said electronic device (4) is not in communication with the server (5), store the integrated information (303) until said electronic device (4) is in communication with the server (5).

7. The electric carrier system as claimed in claim 6, **characterized in that** said electronic device (4) is configured to communicate with said electric carrier device (2) based on Bluetooth protocols.

8. The electric carrier system as claimed in claim 7, **characterized in that**:
said electric carrier device (2) is configured to further store an individual carrier identifier (201) that is unique;
said power supply device (3) is configured to further store a set of reference carrier identifiers (301) and battery information (302) that is related to said power supply device (3);
said electric carrier device (2) is configured to, when said power supply device (3) is disposed on said electric carrier device (2), determine whether the individual carrier identifier (201) matches one of the reference carrier identifiers (301) from the set of reference carrier identifiers (301) stored in said power supply device (3), and to, when it is determined that the individual carrier identifier (201) matches one of the reference carrier identifiers (301) from the set of reference carrier identifiers (301), transmit the carrier information (202) to said power supply device (3) so as to enable said power supply device (3) to integrate the carrier information (202) thus transmitted by said electric carrier device (2) and the battery information (302) stored in said power supply device (3) into the integrated information (303).

9. A method of information provision, the method to be implemented by an electric carrier system, the electric carrier system including an electric carrier device (2) and a power supply device (3), the electric carrier device (2) storing carrier information (202) that is related to the electric carrier device (2), the power supply device (3) adapted to be electrically connected to the electric carrier device (2) and storing integrated information (303) that is related to the power supply device (3) and the carrier information (202), the electric carrier device (2) communicable with a server (5), said method **characterized by**:
by the electric carrier device (2) when the electric carrier device (2) is electrically connected to the power supply device (3), determining a status of a communicable connection between the electric carrier device (2) and the server (5); and
by the electric carrier device (2) when it is determined by the electric carrier device (2) that the electric carrier device (2) is communicably connected with the server (5), transmitting the integrated information (303) to the server (5).

10. The method as claimed in claim 9, further **characterized by**:
by the electric carrier device (2), determining whether an individual carrier identifier (201) stored in the electric carrier device (2) matches one of the reference carrier identifiers from a set of reference carrier identifiers (301) stored in the power supply device (3), and when it is determined that the individual carrier identifier (201) matches one of the reference carrier identifiers from the set of reference carrier identifiers (301), transmitting the carrier information (202) to the power supply device (3) to enable the power supply device (3) to integrate the carrier information (202) and the battery information (302) stored in the power supply device (3) into the integrated information (303), and to provide electrical energy to the electric carrier device (2).
